# EUROPEAN PATENT APPLICATION

(11) **EP 4 832 687 A1**
(43) Date of publication of application: **28.10.2026**
(21) Application number: 25171614.8
(22) Date of filing: 22.04.2025
(51) Int. Cl.: H10B 53/20, H10B 53/10, H10B 12/00, H10D 1/68, H10B 53/30

(54) **A MEMORY DEVICE AND A METHOD FOR MANUFACTURING A MEMORY DEVICE**

(71) Applicant: IMEC VZW, 3001 Leuven (BE)
(72) Inventor: KRUV, Anastasiia, 3212 Pelenberg (BE); HELLINGS, Geert, 1500 Halle (BE); GONZALEZ, Mario, 1390 Bossut-Gottechain (BE)
(74) Representative: AWA Sweden AB

(57) **Abstract**

A memory device (1) comprising
a plurality of conductive lines (12) and a plurality of isolating layers (14), alternately stacked in a vertical direction (100);
a hole (20) extending through the conductive lines (12) and isolating layers (14), the hole (20) extending in the vertical direction (100);
an electrode (40) extending through the hole (20) in the vertical direction (100);
a stressor (50) extending through the hole (20) in the vertical direction (100);
wherein, for each conductive line (12):
a dielectric layer (30) comprising a ferroelectric layer (32) is arranged on an inner surface of the hole (20) through said conductive line (12);
the electrode (40) and the stressor (50) are arranged on an inner side of the dielectric layer (30);
the stressor (50) applies a strain to the ferroelectric layer (32) of the dielectric layer (30).

## Description

### TECHNICAL FIELD

The present inventive concept relates, in general, to a memory device.

### BACKGROUND

A dynamic random-access memory (DRAM) is a memory device comprising a capacitor that stores charge. The charge presence and absence can be coded as logical "1" or "0", respectively. As time progresses, the capacitor loses the charge that it is supposed to store, which eventually leads to information loss. To prevent information loss, the DRAM may be refreshed.

A ferroelectric DRAM is a DRAM wherein the capacitor's dielectric comprises ferroelectric material. A ferroelectric material is a material that have two stable non-volatile polarization states and can switch between them under the electric field application. The use of ferroelectric material reduces or eliminates the need for memory refresh.

### SUMMARY

It is an objective to provide a memory device which is reliable. It is a further objective to provide a memory device with long storage time. It is a further objective to provide a memory device which is compact. It is a further objective to provide a memory device which is easy to manufacture and/or cheap.

In particular, it is an objective to improve ferroelectric memory devices. Thus, it is an objective to provide a ferroelectric memory device which is reliable and/or has a long storage time and/or is compact and/or easy to manufacture and/or cheap.

These and other objectives of the inventive concept are at least partly met by the invention as defined in the independent claims. Preferred embodiments are set out in the dependent claims.

In the following, relative spatial terms such as "top", "bottom", "lower", "vertical", "stacked on top of", are to be understood as denoting locations or directions within a frame of reference of the memory device. In particular, the terms may be understood in relation to a normal direction to a substrate on which the memory device is arranged. Correspondingly, terms such as "lateral" and "horizontal" are to be understood as locations or directions parallel to the substrate.

A vertical direction may be understood as the normal direction to the substrate. A first and a second horizontal direction may respectively be directions parallel to the substrate.

According to a first aspect there is provided a memory device comprising
a plurality of conductive lines and a plurality of isolating layers, alternately stacked in a vertical direction;
a hole extending through the conductive lines and isolating layers, the hole extending in the vertical direction;
an electrode extending through the hole in the vertical direction;
a stressor extending through the hole in the vertical direction;
wherein, for each conductive line:
   a dielectric layer comprising a ferroelectric layer is arranged on an inner surface of the hole through said conductive line;
   the electrode and the stressor are arranged on an inner side of the dielectric layer;
   the stressor applies a strain to the ferroelectric layer of the dielectric layer.

It is a realization that applying strain to the ferroelectric layer by a stressor improves the memory device. The ferroelectric layer is a layer comprising ferroelectric material. Ferroelectric material has two polarization states (+Pr and -Pr). It is a realization that the higher the magnitude of the polarization, the easier it is to distinguish the +Pr and -Pr states from each other. In other words, the memory window (2Pr) between the two states increases. This facilitates a reliable memory device. In particular, it facilitates a memory device with a reliable read operation (as the states are easily distinguishable). As a consequence, the storge time may be long since a large memory window may provide margin for a partial de-polarization before the memory device needs to be refreshed. It may be possible to eliminate the need for refresh.

In accordance with the above, the memory device may be a ferroelectric memory device.

Further, the memory device may be a memory device of the so called 1TnC (one transistor, n capacitors) type, meaning that the device may comprise one transistor (e.g. one select transistor) per n capacitors. The concept of the 1TnC architecture is known in the art.

The plurality of conductive lines stacked in the vertical direction may be called a stack of conductive lines. The conductive lines may extend in a first horizontal direction.

In the context of the invention, a conductive line is a line comprising conductive material, e.g. metal (such as tungsten, molybdenum, ruthenium, copper or titanium), doped polysilicon or titanium nitride. The conductive lines may be word lines. Alternatively, the conductive lines may be plate lines.

As mentioned, the conductive lines and the isolating layers are alternately stacked. Thus, within the stack of conductive lines, neighboring conductive lines are separated by an isolating layer. The isolating layers comprise electrically isolating material, e.g. an oxide. For example, isolating layers may comprise silicon oxide.

There may be a plurality of holes extending through the stack of conductive lines. The plurality of holes may be spaced apart (along the extension of the conductive line) by a first pitch in the first horizontal direction. Further, the memory device may comprise a plurality of stacks of conductive lines, e.g. identical stacks of conductive lines. The plurality of stacks of conductive lines may be spaced apart by a second pitch in a second horizontal direction. The second horizontal direction may be perpendicular to the first horizontal direction. Adjacent stacks of conductive lines may be separated by electrically isolating material, e.g. the same electrically isolating material as the isolating layers.

For each conductive line: the conductive line, the dielectric layer and the electrode may form a capacitor. Thus, a number n capacitors may be stacked on top of each other. The number (n) of stacked capacitors may be equal to the number of stacked conductive lines. Each capacitor may comprise a ferroelectric layer. Accordingly, the memory device may comprise a plurality of stacks of capacitors, spaced apart by the first pitch in the first horizontal direction and spaced apart by the second pitch in the second horizontal direction. In view of the above, the capacitors may be arranged in a 3D matrix. Such a memory device may be called a 3D memory device.

The memory device may further comprise a bit line and a select transistor, wherein the electrode is connected to the bit line via the select transistor. Thus, there may be one select transistor per stack of n capacitors, i.e. the memory device may be an 1TnC memory device. The select transistor may be arranged at the bottom or top of hole. Thus, the select transistor may be arranged below or above the plurality of conductive lines.

In the following, one single stack of capacitors will be discussed (unless otherwise stated), i.e. one single stack of conductive lines and one single hole through said stack of conductive lines. However, the discussion is applicable to all stacks of capacitors of the memory device.

The hole may be arranged such that, in a horizontal plane intersecting one of the conductive lines, the entire perimeter of the hole is in contact with the conductive line. Thus, the hole may be surrounded by the conductive line in the horizontal plane. This may facilitate a large hole area in contact with the conductive line which in turn may facilitate a large capacitance. Alternatively, the hole may be arranged such that, in a horizontal plane intersecting one of the conductive lines, part of the perimeter of the hole is in contact with the conductive line, e.g. at least 1/4 or 1/2 of the perimeter is in contact with the conductive line. In the latter alternative, the other part of the perimeter of the hole may be in contact with the dielectric material separating the stacks of conductive lines.

As mentioned, the electrode extends through the hole in the vertical direction. Thus, the electrode may be a common electrode of the capacitors in the stack of capacitors. Accordingly, the inner side of the capacitors in the stack of capacitors may be directly connected to each other, e.g. without any intermediate transistor. The electrode may comprise electrically conductive material, e.g. metal (such as e.g. tungsten, molybdenum, ruthenium, copper or titanium), doped polysilicon or titanium nitride.

The electrode may be in direct contact with an inner surface of the dielectric layer. Thus, the stressor may be arranged on an inner side of the electrode, e.g. on an inner surface of the electrode. Alternatively, the stressor may be arranged between the electrode and the dielectric layer.

The dielectric layer may comprise solely the ferroelectric layer. Alternatively, the dielectric layer may comprise further layers. For example, the dielectric layer may comprise a first dielectric sublayer between the ferroelectric layer and the conductive line. Additionally, or alternatively, the dielectric layer may comprise a second dielectric sublayer between the ferroelectric layer and the electrode. The dielectric layer may be a tubular layer, i.e. a layer having a tubular shape.

One single ferroelectric layer may extend through the entire hole in the vertical direction. Thus, each respective ferroelectric layer in the hole of each respective conductive line may be a respective portion of the same ferroelectric layer. As an alternative, each respective ferroelectric layer in the hole of each respective conductive line may be an individual layer. Accordingly, in the latter alternative, ferroelectric layers of the holes of neighboring conductive lines may be disconnected from each other.

The ferroelectric layer may comprise any known ferroelectric material, including but not limited to: hafnium oxide, lead zirconate titanate, strontium bismuth tantalate, barium strontium titanate, perovskite ferroelectrics. Such ferroelectric materials may facilitate a large memory window and a reliable memory device. The ferroelectric layer may comprise e.g. HfO₂, BaTiO₃, PbTiO₃, PbZrO₃, KNbO₃, LiNbO₃, LiTaO₃, SbSI, KTiOPO₄, KH2PO₄, PbZrO₃, PbBi₂Nb₂O₉, SrBi₂Ta₂O₉, Ba_{0.73}Sr_{0.27}TiO₃, Bi₄Ti₃O₁₂, HfZrO₂, ZrO₂. In particular, the ferroelectric layer may advantageously comprise HfO₂.

The stressor may be any element applying strain to the ferroelectric layer. The stressor may induce stress (stress corresponding to force per unit area) to the ferroelectric layer, either directly or via an intermediate layer. Said applied stress may then cause strain (i.e. a deformation) in the ferroelectric layer. In the following, statements relating to stress may be equally applicable to strain.

The applied strain may be measured in various ways, as explained below.

Strain may be measured by Raman Spectroscopy, e.g. by measuring the shift in Raman peaks caused by strain in a crystal lattice.

Strain may be measured by X-ray Diffraction (XRD). Herein strain may be measured by analyzing the diffraction patterns of X-rays passing through the material.

Strain may be measured by Transmission Electron Microscopy (TEM). For example, a lamella may be extracted and measured by TEM. The thickness of the lamella may be chosen to be thick enough such that the strain is not fully relaxed by the extraction of the lamella.

Strain may be measured by Electron Backscatter Diffraction (EBSD).

Strain may be measured by nanoindentation. By pressing a hard tip into the surface of the material the resulting deformation may be analyzed and the strain calculated. For example, force-displacement curves of the tip can be recorded. Then with Finite Element Modelling a model of the device can be created and force-displacement curves simulated. By changing the values of initial strain state, it is possible to fit the experimental and modelled curves, this way determining the correct initial strain state.

Further, the strain may be calculated based on the electrical performance of the memory device. For example, the stressor may be removed (e.g. by etching) and the memory device may be electrically measured before and after the removal of the stressor. The stressor may e.g. be fully removed, and the device electrically measured before and after said removal. Alternatively, the stressor may be removed in incremental steps and the device electrically measured between the steps. The strain may be calculated from the electrical measurements using e.g. Technology Computer-Aided Design (TCAD). Further, electrical measurements may be combined with nanoindentation to calculate the strain.

The stressor may be a layer on the inner side of the electrode. In one example, the electrode is a layer, e.g. a tubular layer, on the inner side of the dielectric layer and the stressor is a layer, e.g. a tubular layer, on the inner side of the electrode. Thus, the hole may not necessarily be completely filled. Alternatively, the stressor may fill the inner side of the dielectric layer completely. Thus, the stressor may be a rod at the center of the hole.

The stressor may be a layer, e.g. a tubular layer, between the electrode and the dielectric layer.

It is a realization that arranging the stressor in the hole facilitates efficient application of the strain to the ferroelectric layer. For example, relaxation of the stressor may be inhibited on the inner side of the stressor. Thus, the stress may be directed to elements on an outer side of the stressor, e.g. towards the ferroelectric layer.

It is further a realization that the arrangement of the stressor may be particularly advantageous for a stack of capacitors as described above, since the capacitors may be arranged close to each other and thereby all benefit from a common stressor. In particular, the arrangement of the stressor may be particularly advantageous for a 1TnC device. In a 1TnC device there may be no transistor, between neighboring capacitors, that disturb the strain applied by the stressor.

The memory device may be configured such that, for each conductive line, a magnitude of the strain of the ferroelectric layer is at least 0.03%. In other words, the absolute value of the strain of the dielectric layer may be at least 0.03%. Such a magnitude may enable a sufficient increase of the memory window. Further improvements may be achieved when the magnitude of the strain of the dielectric layer is at least 0.09% or at least 0.12%.

The memory device may be configured such that, for each conductive line, the strain of the ferroelectric layer is compressive strain. Both tensile and compressive strain may be advantageous. Depending on the configuration of the memory device, the most advantageous type of strain may be either tensile or compressive strain. For example, depending on the material of the ferroelectric layer, the most advantageous type of strain may be either tensile or compressive strain. In other words, the strain type of the ferroelectric layer may be tensile strain. Alternatively, the strain type of the ferroelectric layer may be compressive strain. It is a realization that compressive strain may be particularly advantageous, especially when the material of the ferroelectric layer is hafnium oxide.

The memory device may be configured such that, for each conductive line, the hole through the conductive line is completely filled by the dielectric layer, the electrode and the stressor. Such an arrangement may efficiently direct the stress to elements on the outer side of the stressor, e.g. towards the ferroelectric layer. For example, the stressor may be prevented from relaxing towards an inner side when the hole is completely filled.

The memory device may be configured such that, for each conductive line, an area of the stressor is larger than an area of the dielectric layer, when viewed in a horizontal cross-sectional plane. This facilitates a large strain in the ferroelectric layer and/or a flexibility in choice of materials for the stressor and the ferroelectric layer.

Advantageously, for each conductive line, an area of the stressor may be a factor 1.5 larger than an area of the dielectric layer, when viewed in a horizontal cross-sectional plane.

Further advantageously, for each conductive line, an area of the stressor may be a factor 2 larger than an area of the dielectric layer, when viewed in a horizontal cross-sectional plane.

The memory device may be configured such that the hole has a circular cross-section. It is noted that a cross-section which is circular by design may be distorted by fabrication imperfections. Circular should thus be construed as circular within fabrication tolerances. A circular cross-section may facilitate a homogeneous strain distribution in the ferroelectric layer. A circular cross-section may facilitate a high average strain in the ferroelectric layer. Thus, focusing the strain to smaller regions may be inhibited.

As an alternative to a circular cross-section, the cross-section may be oval.

As further alternatives, the cross-section may be square or rectangular.

The hole may not necessarily be a perfect cylinder. The hole may have the shape of a truncated cone. Thus, the area of the hole at the bottom can be smaller than at the top due to imperfect etching.

The memory device may be configured such that the electrode and the stressor comprise a same material. For example, a metal may act as both a stressor and electrode.

In the case where the electrode and the stressor comprise different material, the memory device may be configured such that the electrode is a layer on the inner surface of the dielectric layer, and the stressor is arranged on an inner surface of the layer of the electrode. Thus, the stressor may be arranged on the inner side of the electrode. For example, a non-conductive material may be used as stressor on the inner side of the electrode.

The stressor may comprise one of: silicon nitride, titanium nitride, silicon oxide, metal. Said materials may be particularly useful for applying strain.

In the case where the stressor comprises metal, the metal may be one of: Ti, Ru, W, or Mo.

Alternatively, the metal may be one of: TiN, SiN, Al, Cr, Sc, Cu, Ni, or Ta.

The stressor may apply the strain to the ferroelectric layer by different means, e.g. by intrinsic stress and/or thermal stress. Intrinsic stress may arise during the deposition or growth of a material.

Intrinsic stress may be independent of temperature changes or external forces. Intrinsic stress may be caused by factors such as lattice mismatch and/or grain growth and/or crystallite coalescence and/or the incorporation of impurities during layer deposition. It is a realization that a stressor comprising metal may be an efficient way to utilize intrinsic stress.

Thermal stress may be induced by temperature changes, together with a mismatch of the coefficient of thermal expansion of the materials, that cause differential thermal expansion or contraction of different material. It is a realization that thermal stress may be a well controllable way to tune the stress of the ferroelectric layer.

Thus, the stressor may have a coefficient of thermal expansion differing from a coefficient of thermal expansion of the ferroelectric layer.

According to a second aspect, there is provided a method for manufacturing a memory device, the method comprising:
forming a plurality of conductive lines and a plurality of isolating layers, alternately stacked in a vertical direction;
forming a hole extending through the conductive lines and isolating layers, the hole extending in the vertical direction;
for each conductive line, forming a dielectric layer comprising a ferroelectric layer, the dielectric layer being arranged on an inner surface of the hole through said conductive line;
forming an electrode extending through the hole in the vertical direction;
forming a stressor extending through the hole in the vertical direction;
wherein, for each conductive line:
   the electrode and the stressor are arranged on an inner side of the dielectric layer, with the electrode being in direct contact with an inner surface of the dielectric layer;
wherein the electrode and the stressor are formed by conformal deposition.

The hole may be formed by patterning and etching vertically through the plurality of conductive lines and a plurality of isolating layers, i.e. through the stack of conductive lines.

The dielectric layer, or layers, may be deposited on inner sides of the holes. The dielectric layer, or layers, may be deposited by conformal deposition, e.g. by atomic layer deposition (ALD).

The electrode and the stressor may be deposited on the inner side of the dielectric layer. The electrode and stressor are deposited by conformal deposition, e.g. by atomic layer deposition (ALD). The electrode may be deposited prior to the deposition of the stressor.

Forming the stressor may comprise depositing a material of the stressor at a temperature below 500 °C. Such a temperature may advantageously utilize thermal stress.

A method according to the second aspect may have the same advantages, or similar advantages, as the advantages described in conjunction with the memory device of the first aspect.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 illustrates a cutaway view of memory device.
Fig. 2 illustrates cutaway view of memory device.
Fig. 3 illustrates a cross-sectional view of a memory device.
Fig. 4 illustrates a cross-sectional view of a memory device.
Fig. 5a illustrates a vertical cross-sectional view of a memory device.
Fig. 5b illustrates a horizontal cross-sectional view of a memory device.
Fig. 6 illustrates a cross-sectional view of a memory device.
Fig. 7 illustrates a circuit diagram of a memory device.
Fig. 8 illustrates a cutaway view of memory device during production.

### DETAILED DESCRIPTION

In cooperation with attached drawings, the technical contents and detailed description of the present invention are described thereinafter according to preferable embodiments, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

In the following, axes X, Y and Z indicate a first horizontal direction, a second horizontal direction transverse to the first horizontal direction, and a vertical direction, respectively. The X- and Y-direction are parallel to a main plane of a substrate 2. The Z-direction is parallel to a normal direction to the substrate 2.

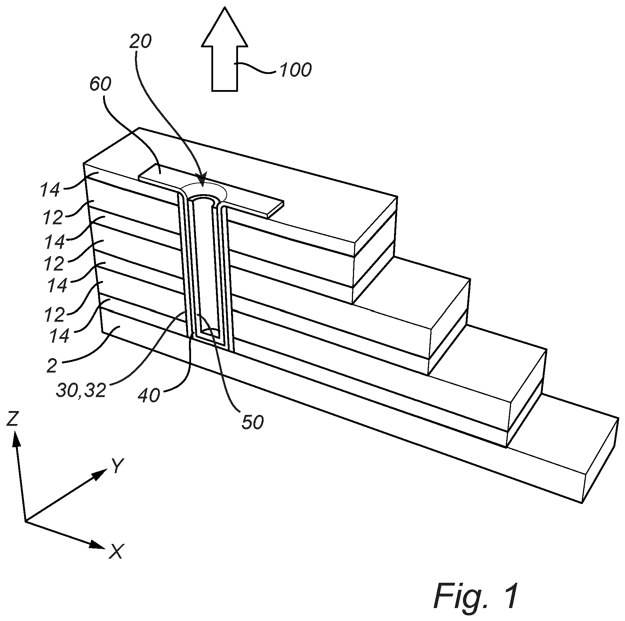

Fig. 1 illustrates a cutaway view of memory device 1. The memory device 1 comprises a plurality of conductive lines 12 and a plurality of isolating layers 14, alternately stacked in a vertical direction 100. In the figure, the vertical direction 100 corresponds to the Z-direction. In other words, the figure shows one stack of conductive lines. In the figure, the stack of conductive lines is arranged on a substrate 2.

The memory device 1 comprises a hole 20 extending through the conductive lines 12 and isolating layers 14, the hole 20 extends in the vertical direction 100. For illustrative purposes, the memory device has been cut along a vertical plane, at the center of the hole 20. The cutaway may be seen as a mirror image of the visible features.

In the figure, a dielectric layer 30 comprising a ferroelectric layer 32 is arranged on an inner surface of the hole 20. In the illustrated case, the dielectric layer 30 comprises a sole ferroelectric layer 32. However, as will be discussed below, the dielectric layer 30 may comprise additional dielectric sublayers. The illustrated dielectric layer 30 has a tubular shape (albeit cut in half due to the cutaway view).

In the figure, an electrode 40 extends through the hole 20 in the vertical direction 100. The electrode 40 is arranged on an inner surface of the dielectric layer 30. The illustrated electrode 40 has a tubular shape (albeit cut in half due to the cutaway view).

In the figure, a stressor 50 extends through the hole 20 in the vertical direction 100. The stressor 50 is arranged on an inner surface of the electrode 40. The illustrated stressor 50 has a tubular shape (albeit cut in half due to the cutaway view).

Along the vertical direction 100, each intersection between the conductive line 12 and the electrode 40, separated by the dielectric layer 30, may be seen as a capacitor. Thus, the illustrated memory device 1 may be considered to comprise a stack of 3 capacitors.

The illustrated conductive lines 12 may be word lines or plate lines.

The figure further illustrates a bit line 60 connected to the electrode 40. The bit line 60 may be connected to the electrode via a select transistor (not shown).

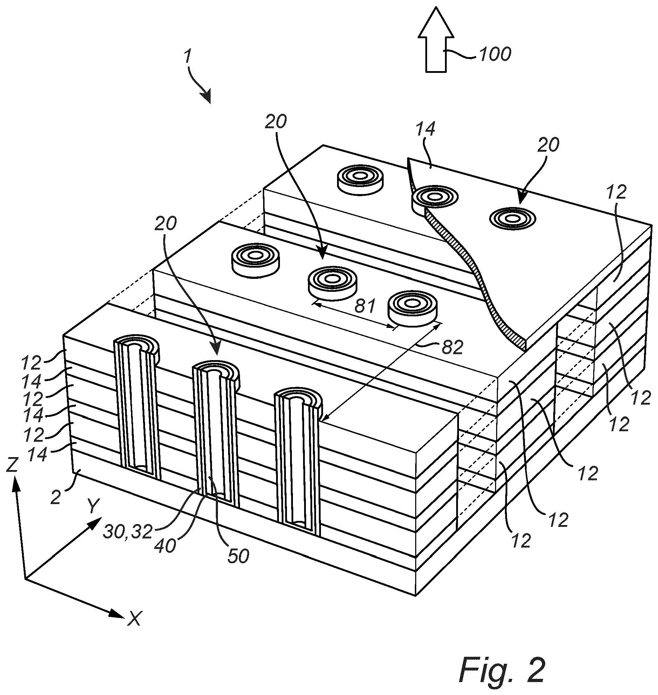

Fig. 2 illustrates a cutaway view of memory device 1. The memory device 1 comprises three stacks of conductive lines 12, wherein each stack of conductive lines comprises three holes 20. The illustrated stacks of conductive lines 12 are arranged on a substrate 2. The holes 20 are spaced apart by a first pitch 81 in the first horizontal direction (X-direction). The holes 20 are spaced apart by a second pitch 82 in the second horizontal direction (Y-direction). Thus, in the figure, the stacks of conductive lines are also spaced apart by a second pitch 82 in the second horizontal direction. The first pitch 81 may advantageously be below 300 nm or further advantageously below 150 nm. The second pitch 82 may advantageously be below 300 nm or further advantageously below 150 nm. The first and second pitches may respectively be in the ranges of 100-120 nm. Such pitches may facilitate synergetic strain effects between the holes in the first and second direction respectively, i.e. that each stressor 50 applies strain to the ferroelectric layers 32 of neighboring holes 20, in addition to applying strain to the ferroelectric layer 32 of its own hole 20. The holes 20 may be arranged in a square lattice, as illustrated, or in a staggered lattice, or in any other lattice.

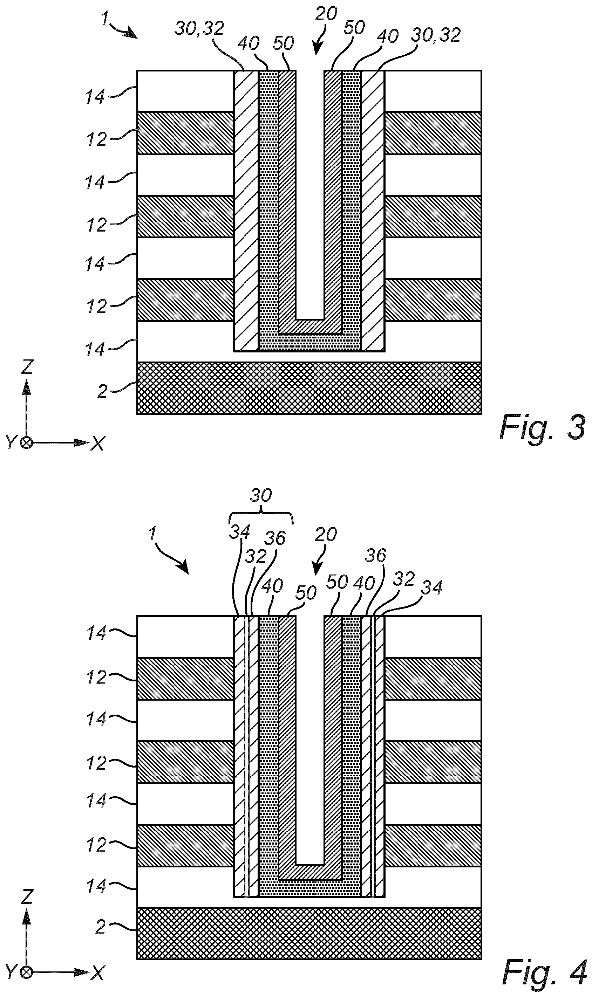

Fig. 3 illustrates a cross-sectional view of a memory device 1, the cross-section is taken in the XZ plane. The illustrated memory device 1 is similar to those of Figs 1 and 2 and comprises a dielectric layer 30 comprising a ferroelectric layer 32 wherein the dielectric layer 30 comprises a sole ferroelectric layer 32.

Fig. 4 illustrates a cross-sectional view of a memory device 1, the cross-section is taken in the XZ plane. The figure illustrates that the dielectric layer 30 may comprise further layers in addition to the ferroelectric layer 32. In the figure, the dielectric layer 30 comprises a first dielectric sublayer 34 between the ferroelectric layer 32 and the conductive line 12 and a second dielectric sublayer 36 between the ferroelectric layer 32 and the electrode 40. In Fig. 4, features other than the dielectric layer 30 may be arranged in the same or similar way as in Fig. 1.

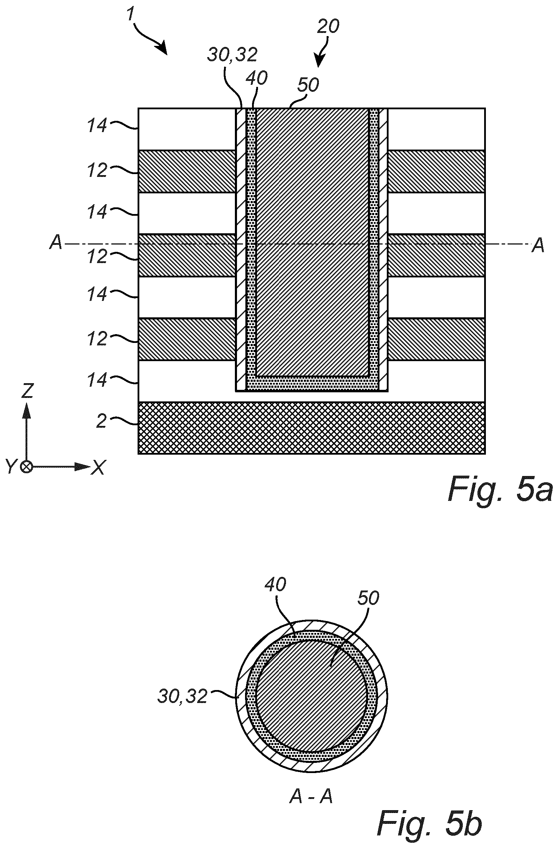

Fig. 5a illustrates a cross-sectional view of a memory device 1, the cross-section is taken in the XZ plane. Fig. 5b illustrates a cross-sectional view of the same memory device 1, the cross-section is taken along horizontal plane A-A indicated in Fig. 5a (in the XY plane). In the illustrated memory device 1, the hole 20 is completely filled by the dielectric layer 30, the electrode 40 and the stressor 50. In the illustrated memory device 1, the hole 20 has a circular cross-section, as seen in Fig. 5b. Further, in the figure, the area of the stressor 50 is larger than the area of the dielectric layer 30. In the figure, the stressor 50 fills the portion of the hole 20 on the inner side of the electrode 40 completely.

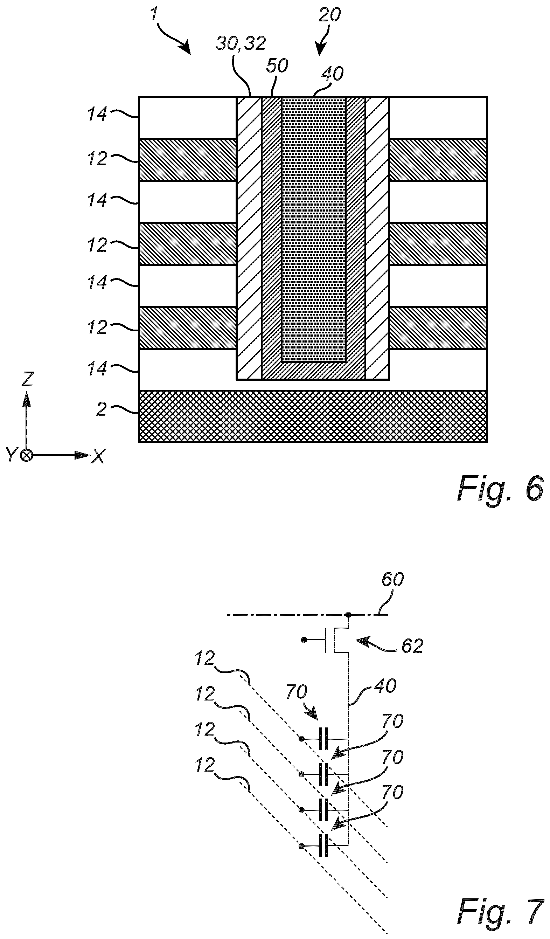

Fig. 6 illustrates a cross-sectional view of a memory device 1, the cross-section is taken in the XZ plane. In the illustrated memory device 1, the hole 20 is completely filled by the dielectric layer 30, the electrode 40 and the stressor 50. The figure illustrates that the stressor 50 may be a layer, e.g. a tubular layer, between the electrode 40 and the dielectric layer 30. In the figure, the electrode 40 fills the portion of the hole 20 on the inner side of the stressor 50 completely.

Fig. 7 illustrates a circuit diagram of a memory device 1. The memory device comprises a stack of four conductive lines 12 and an electrode 40. Four transistors 70 are illustrated at the intersection between the conductive line 12 and the electrode 40, as formed by the dielectric layer 30 (not shown). The figure further shows a bit line 60 and a select transistor 62, wherein the electrode 40 is connected to the bit line 60 via the select transistor 62.

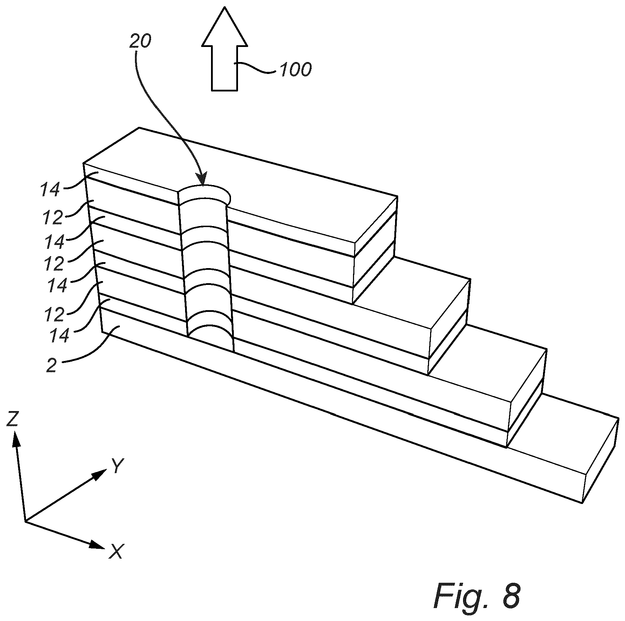

Fig. 8 illustrates a cutaway view of a stack of conductive lines 12 during production of the memory device 1. Fig. 8 may be seen as a step in the production of the memory device 1 of Fig. 1. In Fig. 8, a hole 20 extending through the conductive lines 12 and isolating layers 14 has been formed, e.g. by etching.

The dielectric layer 30, or layers, may subsequently be deposited on inner sides of the hole 20. The dielectric layer 30, or layers, may be deposited by conformal deposition, e.g. by atomic layer deposition (ALD).

The electrode 40 and the stressor 50 may subsequently be deposited on the inner side of the dielectric layer 30. The electrode 40 and the stressor 50 may be deposited by conformal deposition, e.g. by atomic layer deposition (ALD). The electrode 40 may be deposited prior to the deposition of the stressor 50.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A memory device (1) comprising
a plurality of conductive lines (12) and a plurality of isolating layers (14), alternately stacked in a vertical direction (100);
a hole (20) extending through the conductive lines (12) and isolating layers (14), the hole (20) extending in the vertical direction (100);
an electrode (40) extending through the hole (20) in the vertical direction (100);
a stressor (50) extending through the hole (20) in the vertical direction (100);
wherein, for each conductive line (12):
a dielectric layer (30) comprising a ferroelectric layer (32) is arranged on an inner surface of the hole (20) through said conductive line (12);
the electrode (40) and the stressor (50) are arranged on an inner side of the dielectric layer (30);
the stressor (50) applies a strain to the ferroelectric layer (32) of the dielectric layer (30).

2. The memory device of claim 1,
wherein, for each conductive line, a magnitude of the strain of the ferroelectric layer is at least 0.03%.

3. The memory device of claim 1 or 2,
wherein, for each conductive line, the strain of the ferroelectric layer is compressive strain.

4. The memory device of any one of the preceding claims,
wherein, for each conductive line, the hole through the conductive line is completely filled by the dielectric layer, the electrode and the stressor.

5. The memory device of any one of the preceding claims,
wherein, for each conductive line,
an area of the stressor is larger than an area of the dielectric layer, when viewed in a horizontal cross-sectional plane.

6. The memory device of any one of the preceding claims, wherein the hole has a circular cross-section.

7. The memory device of any one of the preceding claims,
wherein the electrode and the stressor comprise a same material.

8. The memory device of any one of claims 1-6,
wherein the electrode and the stressor comprise different material, the electrode being a layer on the inner surface of the dielectric layer, the stressor being arranged on an inner surface of the layer of the electrode.

9. The memory device of any one of the preceding claims,
wherein the ferroelectric layer comprises one of: hafnium oxide, lead zirconate titanate, strontium bismuth tantalate, barium strontium titanate, perovskite ferroelectrics.

10. The memory device of any one of the preceding claims,
wherein the stressor comprises one of: silicon nitride, titanium nitride, silicon oxide, metal.

11. The memory device of claim 10,
wherein the stressor comprises metal, the metal being: Ti, Ru, W, or Mo.

12. The memory device of any one of the preceding claims,
wherein the stressor has a coefficient of thermal expansion differing from a coefficient of thermal expansion of the ferroelectric layer.

13. The memory device of any one of the preceding claims, further comprising
a bit line and a select transistor, wherein the electrode is connected to the bit line via the select transistor.

14. A method for manufacturing a memory device, the method comprising:
forming a plurality of conductive lines and a plurality of isolating layers, alternately stacked in a vertical direction;
forming a hole extending through the conductive lines and isolating layers, the hole extending in the vertical direction;
for each conductive line, forming a dielectric layer comprising a ferroelectric layer, the dielectric layer being arranged on an inner surface of the hole through said conductive line;
forming an electrode extending through the hole in the vertical direction;
forming a stressor extending through the hole in the vertical direction;
wherein, for each conductive line:
the electrode and the stressor are arranged on an inner side of the dielectric layer, with the electrode being in direct contact with an inner surface of the dielectric layer;
wherein the electrode and the stressor are formed by conformal deposition.

15. The method of claim 14, wherein forming the stressor comprises depositing a material of the stressor at a temperature below 500 °C.
